# EUROPEAN PATENT APPLICATION

(11) **EP 4 645 372 A1**
(43) Date of publication of application: **05.11.2025**
(21) Application number: 23909166.3
(22) Date of filing: 03.08.2023
(51) Int. Cl.: H01L 21/3065

(54) **ETCHING METHOD AND ETCHING SYSTEM**

(30) Priority: 30.12.2022 CN 202211736974; 30.12.2022 CN 202211739527
(71) Applicant: Jiangsu Leuven Instruments Co. Ltd, Xuzhou, Jiangsu 221300 (CN)
(72) Inventor: HAN, Yuanzheng, Xuzhou, Jiangsu 221300 (CN); ZHU, Kaifang, Xuzhou, Jiangsu 221300 (CN); GUO, Chunxiang, Xuzhou, Jiangsu 221300 (CN); REN, Zhouyi, Xuzhou, Jiangsu 221300 (CN); XU, Kaidong, Xuzhou, Jiangsu 221300 (CN)
(74) Representative: Eisenführ Speiser
(86) International application number: PCT/CN2023/110891
(87) International publication number: WO 2024/139224

(57) **Abstract**

Provided in the present application are an etching method and an etching system. The method comprises: providing a structure to be etched, wherein said structure is covered with a patterned mask layer; carrying out first etching on said structure by taking the mask layer as a mask, so as to form a first trench; and then carrying out second etching on the first trench by taking the mask layer as the mask, wherein one of the first etching and the second etching is plasma etching, and the other is ion beam etching, so as to carry out bottom surface modification on the first trench to obtain a second trench. In this way, the ion beam etching is carried out after the plasma etching, or the plasma etching is carried out after the ion beam etching; the first trench can be modified by means of a process different from a process for forming the first trench, so as to form a round and smooth trench bottom, thereby avoiding the formation of micro-trenches, overcoming structural defects caused during machining and manufacturing of trench devices, and improving the performance of the devices.

## Description

The present application claims the priority to the Chinese Patent Application No. 202211736974.7, titled "ETCHING METHOD AND ETCHING SYSTEM", filed on December 30, 2022 with the China National Intellectual Property Administration, and to the Chinese Patent Application No. 202211739527.7, titled "ETCHING METHOD AND ETCHING SYSTEM", filed on December 30, 2022 with the China National Intellectual Property Administration, both of which are incorporated herein by reference in their entirety.

### FIELD

The present application relates to the technical field of semiconductors and, in particular, to an etching method and an etching system.

### BACKGROUND

Among various semiconductor materials, silicon carbide (SiC) stands out due to its excellent physical and electrical properties as the next-generation semiconductor material for microelectronic devices and circuits, following germanium, silicon, and gallium arsenide. Silicon carbide is an ideal material for achieving the combination of high temperature with high power, high frequency, and radiation resistance, and has emerged as one of the most promising third-generation wide-bandgap semiconductor materials.

Currently, during the etching of silicon carbide materials, a microtrenching effect may occur. Specifically, V-shaped grooves, known as micro-trenches, form near the bottom of trench sidewalls. Since a power device operates under high-voltage and high-power conditions for a long time, the internal working electric field strength is high, and it is easy to exceed the maximum critical electric field strength locally at the micro-trenches formed by etching, leading to local breakdown and affecting the reliability and service life of the device. At present, although conventional etching processes can basically control the micro-trenches, the formation of the micro-trenches cannot be completely avoided, thereby affecting the device performance.

### SUMMARY

In view of this, an object of the present application is to provide an etching method and an etching system, which can eliminate the formation of micro-trenches and improve the device performance. The solutions are provided as follows.

In a first aspect, an etching method is provided according to the present application, including:
providing a structure to be etched, which is covered with a patterned mask layer;
carrying out first etching on the structure to be etched while taking the mask layer as a shield, so as to form a first trench; and
carrying out second etching on the first trench while taking the mask layer as the mask, so as to form a second trench.

One of the first etching and the second etching is plasma etching, and the other is ion beam etching.

In a second aspect, an etching system is further provided according to an embodiment of the present application, including an etching apparatus and a controller.

The etching apparatus includes a first etching apparatus for carrying out a plasma etching and a second etching apparatus for carrying out an ion beam etching, and the controller is configured to carry out the etching method.

An etching method and an etching system are provided according to the embodiments of the present application. The etching method includes: providing a structure to be etched, which is covered with a patterned mask layer; carrying out first etching on the structure to be etched while taking the mask layer as a shield, so as to form a first trench; and carrying out second etching on the first trench while taking the mask layer as the mask, so as to form a second trench. One of the first etching and the second etching is plasma etching, and the other is ion beam etching, so as to modify a bottom surface of the first trench to obtain a second trench. In this way, by performing the ion beam etching after the plasma etching, or performing the plasma etching after the ion beam etching, the first trench can be modified through a process different from the one used to form the first trench, thereby forming a smooth curved trench bottom, avoiding the formation of micro-trenches, addressing structural defects arising from the processing and manufacturing of grooved devices, and improving device performance.

### BRIEF DESCRIPTION OF THE DRAWINGS

For clear illustration of the technical solutions according to embodiments of the present application or conventional techniques, hereinafter briefly described are the drawings to be used in description of embodiments of the present application or conventional techniques. Apparently, the drawings in the following descriptions only relate to some embodiments of the present application, and other drawings may be obtained by those skilled in the art based on these drawings without creative efforts.
FIG. 1 shows a flow chart of an etching method provided according to an embodiment of the present application;
FIG. 2 shows a schematic structural view of a structure to be etched according to an embodiment of the present application;
FIG. 3 shows a schematic structural view of a structure to be etched according to another embodiment of the present application;
FIG. 4 shows a flow chart of an etching method provided according to another embodiment of the present application;
FIG. 5 shows a schematic structural view of a structure to be etched according to an embodiment of the present application, which has a first trench;
FIG. 6 shows a schematic structural view of a structure to be etched according to an embodiment of the present application, which has a second trench;
FIG. 7 shows a flow chart of an etching method provided according to yet another embodiment of the present application;
FIG. 8 shows a schematic structural view of a structure to be etched according to another embodiment of the present application, which has a first trench;
FIG. 9 shows a schematic structural view of a structure to be etched according to another embodiment of the present application, which has a second trench; and
FIG. 10 shows a schematic structural view of an etching system provided according to an embodiment of the present application.

### DETAILED DESCRIPTION OF THE EMBODIMENTS

In order to make the above objects, features, and advantages of the present application more apparent and understandable, implementations of the present application will be described in detail below with reference to the drawings.

Various details will be set forth in following description to facilitate a full understanding of the present application. However, the present application may be implemented in a manner different from those described herein, and those skilled in the art may make some modifications without departing from concepts of the present application. Therefore, the present application is not limited by the embodiments disclosed hereinafter.

The present application will be described in detail with reference to schematic drawings. In following description, a cross-sectional view partially enlarged to show a device structure for purpose of illustration may not be drawn in scale. The schematic drawings are only illustrative and are not intended to limit a protection scope of the present application. In addition, three spatial dimensions of a length, a width, and a depth shall be included in actual production.

As described in the background, the current conventional etching processes can basically control the micro-trenches, but the formation of the micro-trenches cannot be completely eliminated, thereby affecting the device performance.

In view of the above technical issues, an etching method and an etching system are provided according to embodiments of the present application. The etching method includes: providing a structure to be etched, on which a patterned mask layer is covered; carrying out first etching on the structure to be etched while taking the mask layer as a shield, so as to form a first trench; and carrying out second etching on the first trench while taking the mask layer as the mask. One of the first etching and the second etching is plasma etching, and the other is ion beam etching. The bottom surface of the first trench is modified to obtain the second trench. In this way, by performing ion beam etching after plasma etching, or performing plasma etching after ion beam etching, the first trench can be modified through a process different from the one used to form the first trench, thereby forming a smooth curved trench bottom. Thus, the formation of micro-trenches can be avoided, addressing structural defects arising from the processing and manufacturing of grooved devices, and improving the device performance.

For ease of understanding, an etching method and an etching system provided according to embodiments of the present application will be described in detail below with reference to the drawings.

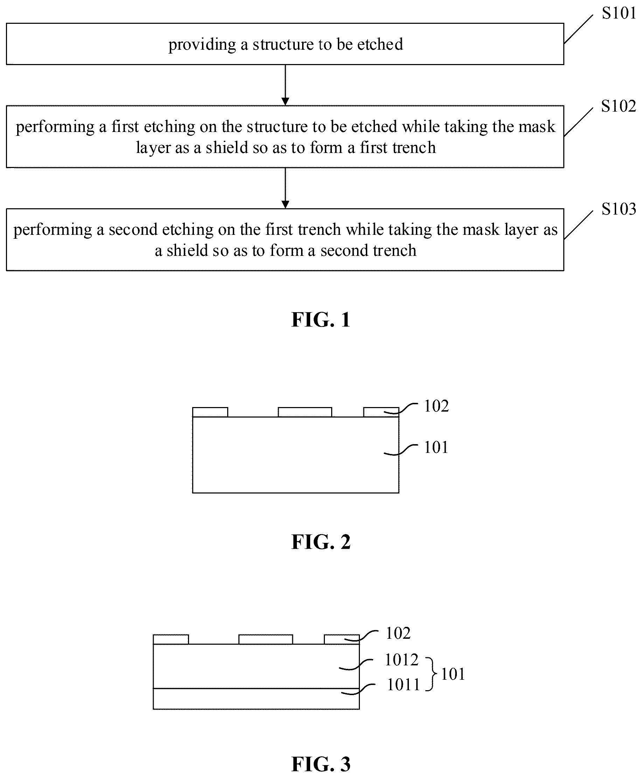

Referring to FIG. 1, it shows a flow chart of an etching method provided according to an embodiment of the present application. The method includes the following steps.

In S101, a structure to be etched is provided.

In the embodiments of the present application, a structure to be etched may be provided, and is covered with a patterned mask layer, so as to etch the structure based on the pattern of the mask layer, thereby obtaining a patterned structure. The size and shape of the structure to be etched are not specifically limited herein.

The structure to be etched may be a silicon carbide substrate. Referring to FIG. 2, it is a schematic structural view of a structure to be etched according to an embodiment of the present application. The structure 101 to be etched is a silicon carbide substrate, which is covered with a patterned mask layer 102.

Alternatively, the structure to be etched may include a substrate and a silicon carbide layer located on one side of the substrate, and the silicon carbide layer may be subsequently etched based on the patterned mask layer. The substrate may be, for example, a silicon substrate. Referring to FIG. 3, it shows a schematic structural view of a structure to be etched according to another embodiment of the present application. The structure to be etched includes a substrate 1011 and a silicon carbide layer 1012 stacked one on top of another, and the silicon carbide layer 1012 is covered with a mask layer 102.

In a possible implementation, the patterned mask layer may be formed on the structure to be etched by using nanoimprinting, photolithography, or etching method. The material of the mask layer may be at least one of photoresist, silicon oxide, silicon nitride, and metal. The critical dimension (CD) of the mask layer may be 1 µm.

Specifically, nanoimprinting transfers patterns through contact printing, thereby forming a patterned mask layer on the structure to be etched. The nanoimprinting process is simple, cost-effective, suitable for mass production, and produces patterns with high resolution. Photolithography involves coating the surface of the structure to be etched with a layer of highly photosensitive photoresist, illuminating the surface of the structure to be etched with light after passing by a mask, causing a reaction in the photoresist exposed to light, and then using a specific solvent to remove either the exposed or unexposed photoresist, thus transferring the circuit pattern from the mask to the structure to be etched with higher resolution.

In S102, first etching is carried out on the structure to be etched while taking the mask layer as a shield, so as to form a first trench.

In S103, second etching is carried out on the first trench while taking the mask layer as the mask, so as to form a second trench.

In the embodiments of the present application, a first etching may be performed on the structure to be etched while taking a mask layer as a shield, so as to form a first trench. Subsequently, a second etching may be performed on the first trench while taking the mask layer as a shield. One of the first etching and the second etching is plasma etching, and the other is ion beam etching. The bottom surface of the first trench is modified to obtain a second trench. In this way, by performing ion beam etching after plasma etching or performing plasma etching after ion beam etching, the first trench can be modified through a process different from the one used to form the first trench, thereby forming a smooth curved trench bottom. This avoids the formation of micro-trenches and addresses structural defects arising from the processing and manufacturing of grooved devices, thereby improving the device performance.

Before performing the first etching on the structure to be etched while taking the mask layer as a shield so as to form the first trench, the structure to be etched may be placed into a first etching chamber. If the first etching is plasma etching, the first etching chamber is a plasma etching chamber; or if the first etching is ion beam etching, the first etching chamber is an ion beam etching chamber. Before performing the second etching on the first trench while taking the mask layer as a shield, the structure to be etched, on which the first trench has been formed, may be transferred to a second etching chamber. If the second etching is plasma etching, the second etching chamber is a plasma etching chamber; or if the second etching is ion beam etching, the second etching chamber is an ion beam etching chamber. The plasma etching chamber contains a first etching apparatus for performing plasma etching, and the ion beam etching chamber contains a second etching apparatus for performing ion beam etching.

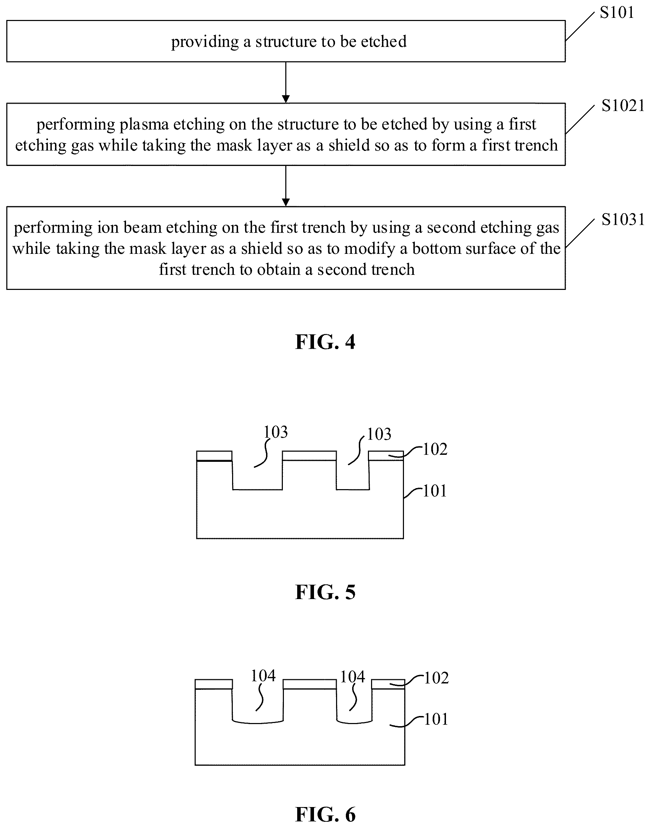

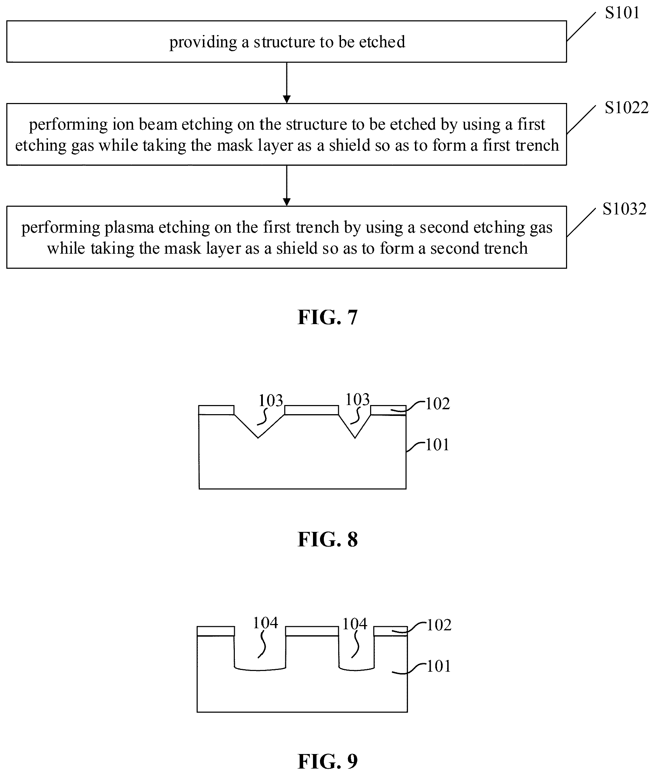

Referring to FIG. 4, it shows a flow chart of an etching method provided according to another embodiment of the present application. S102 may correspond to S1021, while taking a mask layer as a shield, carrying out plasma etching on the structure to be etched with a first etching gas so as to form a first trench. S103 may correspond to S1031, while taking a mask layer as a shield, carrying out ion beam etching on the first trench with a second etching gas so as to modify the bottom surface of the first trench and obtain a second trench. Alternatively, referring to FIG. 7, it shows a flow chart of an etching method provided according to yet another embodiment of the present application. S102 may correspond to S1022, while taking the mask layer as a shield, carrying out ion beam etching on the structure to be etched with a second etching gas to form a first trench. S103 may correspond to S1032, while taking mask layer as a shield, carrying out plasma etching on the first trench with a first etching gas to form a second trench.

The two cases will be described below.

In S1021, while taking the mask layer as a shield, the plasma etching is performed on the structure to be etched with a first etching gas to form a first trench.

In the embodiment of the present application, while taking the mask layer as a shield, the plasma etching may be performed on the structure to be etched with the first etching gas to form the first trench. Referring to FIG. 5, it shows a schematic structural view of a structure to be etched according to an embodiment of the present application, which has a first trench. The first trench 103 may be formed by introducing the first etching gas perpendicularly onto the structure to be etched.

The first etching gas may include SF₆ and O₂. When the structure to be etched includes silicon carbide material, SF₆ may serve the purpose of ion bombardment and ionize to produce fluorine ions, which react with silicon carbide to generate volatile substances, thereby accelerating the etching rate. O₂ may be mixed into SF₆ to control the etching rate and trench shape, protecting the trench sidewalls. The flow ratio of SF₆ to O₂ may be 1:2, and the total flow of SF₆ and O₂ may account for 5% or more of the flow of the first etching gas, which can maintain a high etching rate and effectively protect the trench shape.

The first etching gas may further include HBr, which serves the purpose of ion bombardment etching and reacts with silicon carbide to generate polymers that adhere to the sidewalls of the first trench, thereby protecting the sidewalls from being etched.

The first etching gas may further include an inert gas, which may include at least one of Ar, He, Kr, and N₂. The inert gas may achieve physical etching and protect the structure to be etched from over-etching. When the first etching gas is used to form the first trench, the proportion of flow of the inert gas in the first etching gas may be greater than 30%.

In an embodiment of the present application, the plasma etching may include inductively coupled plasma (ICP) etching or capacitively coupled plasma (CCP) etching. The structure to be etched may be subjected to ICP etching by using an ICP processing apparatus or to CCP etching by using a CCP processing apparatus. The ICP processing apparatus introduces the energy of a radio frequency (RF) power source into the reaction chamber in the form of magnetic field coupling via an induction coil, thereby generating plasma for etching. The CCP processing apparatus forms plasma within the reaction chamber through capacitive coupling of an RF or direct current (DC) power source applied to the electrodes, achieving etching.

In a possible implementation, the step of carrying out plasma etching on the structure to be etched with a first etching gas while taking a mask layer as a shield so as to form a first trench may include: determining the chamber pressure, the RF power of the first RF source, the RF power of the second RF source, and the temperature of the lower electrode required during plasma etching based on the preset depth and width of the second trench. The first RF source is used to ionize the first etching gas to form plasma, the second RF source is used to control a downward movement of the plasma to contact the structure to be etched, thereby achieving anisotropic etching, and the lower electrode is used to place the structure to be etched and is connected to the second RF source. Subsequently, while taking the mask layer as a shield, plasma etching is performed on the structure to be etched with the first etching gas based on the chamber pressure, RF power of the first RF source, RF power of the second RF source, and temperature of the lower electrode required during plasma etching, thus forming the first trench with a target depth and a target width. In this way, it is possible to form the first trenches extending perpendicularly and having different aspect ratios based on device design requirements.

In an embodiment of the present application, the chamber pressure required during plasma etching may be larger than or equal to 5 mT and less than or equal to 80 mT; the RF power of the first RF source may be larger than or equal to 50 W and less than or equal to 1200 W; the RF power of the second RF source may be less than or equal to 500 W; and the temperature of the lower electrode may be less than or equal to 60 degrees Celsius.

If the structure to be etched includes silicon carbide material and the first etching is plasma etching, the chamber pressure required during plasma etching may be 10 mT; the RF power of the first RF source may be 400 W; the RF power of the second RF source may be 80 W; and the first etching gas may include SF₆, O₂, and Ar. The gas flow rate of the first etching gas may be larger than or equal to 40 sccm and less than or equal to 120 sccm.

In S1031, while taking a mask layer as a shield, ion beam etching is carried out on the first trench with a second etching gas to modify the bottom surface of the first trench and obtain a second trench.

In the embodiment of the present application, while taking the mask layer as a shield, ion beam etching (IBE) may be performed on the first trench with the second etching gas to modify its bottom surface and obtain a second trench. The second trench may have a U-shaped structure. In this case, after plasma etching, the first trench may be modified by ion beam etching performed with the second etching gas so as to form a smooth curved trench bottom, thereby avoiding the formation of micro-trenches and achieving a silicon carbide trench structure with high etching rate, high steepness, high etching selectivity, no micro-trenches, a smooth curved bottom, and low damage. This addresses the structural defects arising from the processing and manufacturing of silicon carbide grooved devices and improves the device performance. Referring to FIG. 6, it shows a schematic structural view of a structure to be etched according to an embodiment of the present application, which has a second trench. A U-shaped second trench 104 is formed in the structure 101 to be etched.

The second trench has a high aspect ratio and has both vertical sidewalls and a smooth curved bottom in a U-shaped structure, so that the silicon carbide trench structure can have a high channel density. Channel density is defined as the channel width in the active region. Thus, the on-state resistance of the device is significantly reduced. This structure eliminates neck region resistance of the Junction Field-Effect Transistor (JFET), thus greatly increasing the primitive cell density, enhancing the current handling capability of the power semiconductor, significantly improving the performance of the silicon carbide device, and extending its service life.

In an embodiment of the present application, the second trench may include multiple independent sub-trenches. The multiple independent sub-trenches may have the same depth but not necessarily the same width, thereby forming trenches with different widths based on actual needs. For example, some of the sub-trenches may have a width of 2.5 µm, whereas others may have a width of 4 µm. In FIG. 6, two second trenches 104 of different widths are formed on the structure to be etched.

If the structure to be etched includes silicon carbide material, the second etching gas may include an inert gas, which includes at least one of Ar, He, Kr, and Xe, so that the inert gas is ionized into an ion beam for etching and modifying the bottom surface of the first trench.

The second etching gas may further include a reactive gas that can chemically react with silicon carbide to increase the etching rate. The reactive gas may include at least one of SF₆, CHF₃, CF₄, and NF₃.

In a possible implementation, before performing plasma etching on the structure to be etched with the first etching gas while taking the mask layer as a shield to form the first trench, the structure to be etched may be placed into a plasma etching chamber. For example, the structure to be etched may be placed into the plasma etching chamber by a robotic arm.

Before performing ion beam etching on the first trench with the second etching gas while taking the mask layer as a shield, the structure to be etched, on which the first trench has been formed, may be transferred to an ion beam etching chamber. For example, the structure to be etched may be taken out of the plasma etching chamber and then placed into the ion beam etching chamber by a robotic arm.

The structure to be etched may be placed into the plasma etching chamber, and the first etching gas may be introduced into the plasma etching chamber, so as to form the first trench through plasma etching. Subsequently, the structure to be etched with the first trench may be transferred to the ion beam etching chamber, and the second etching gas may be introduced into the ion beam etching chamber, so that the bottom surface of the first trench can be etched and modified by ionizing the second etching gas. In this way, it is possible to obtain trenches having arc-shaped bottoms with different curvatures.

In another possible implementation, the process of using the first etching gas to perform plasma etching on the structure to be etched and the process of using the second etching gas to perform ion beam etching on the first trench may be carried out in the same chamber, e.g., the ion beam etching chamber, the plasma etching chamber, or any other reaction chamber. In this case, before using the first etching gas to perform plasma etching on the structure to be etched, the structure to be etched may be placed into the reaction chamber until both the plasma etching and the ion beam etching are completed.

The apparatus used for ion beam etching may be at least one of an ion beam etching apparatus, a reaction ion beam etching (RIBE) apparatus, and a chemical ion beam etching (CIBE) apparatus. Ion beam etching refers to the process of filling an ion source discharge chamber with an inert gas, ionizing the inert gas to form ions, and enabling the ions to be in a beam shape by a grid and accelerated, so that the ion beam with certain energy enters the working chamber, moves towards the solid surface and bombards the solid surface atoms, causing the material atoms to sputter and achieving the etching purpose. Reaction ion beam etching involves filling the ion source with a reactive gas and ionizing the reactive gas as well, which not only achieves physical etching by the ion beam but also enables the reactive gas to undergo chemical reactions with the structure to be etched, accelerating the etching rate. Chemical ion beam etching involves generating a high-energy ion beam through an ion source and filling the vacuum chamber with a reactive gas to etch the structure to be etched. In this way, the ions bombarding the structure to be etched and the gas reacting with the structure to be etched can be controlled separately, meaning that the anisotropic and isotropic etching of the structure to be etched can be independently controlled.

In an embodiment of the present application, the modification effect of the second etching gas on the bottom surface of the first trench may be influenced by changing parameters such as the incidence angle of the ion beam, the energy of the ion beam, and the beam current density of the ion beam, thereby obtaining second trenches with different depths and curved bottoms.

The step of carrying out ion beam etching on the first trench with a second etching gas while taking a mask layer as a shield to modify the bottom surface of the first trench and obtain a second trench may include: determining the energy and beam current density of the ion beam based on the preset depth and width or the target depth and width of the second trench, wherein the ion beam is formed by ionizing the second etching gas; and while taking the mask layer as a shield, performing ion beam etching on the first trench with the second etching gas based on the energy and beam current density of the ion beam to modify the bottom surface of the first trench and obtain the second trench. In this way, the second trenches with preset widths and depths can be fabricated, with an improved accuracy of etching, and the formed second trenches exhibit high steepness. Furthermore, relevant parameters may be adjusted to regulate the perpendicularity of the trench sidewalls and the etching rate, thereby obtaining trenches of a specified depth.

In an embodiment of the present application, when the second etching is ion beam etching, the ion beam may be incident perpendicularly to the structure to be etched. The rotational speed of the ion beam emitting device may be less than or equal to 20 rpm. The energy of the ion beam may be greater than or equal to 400 V and less than or equal to 1000 V. The accelerating voltage of the ion beam may be 20% of the energy of the ion beam. The beam current density of the ion beam may be greater than or equal to 100 mA and less than or equal to 1000 mA.

If the structure to be etched includes silicon carbide material and the second etching is ion beam etching, the energy of the ion beam may be 500 V; the accelerating voltage of the ion beam may be 100 V; the beam current density of the ion beam may be 400 mA; the chamber pressure required during ion beam etching may be 3 mT; the gas flow rate of the second etching gas may be greater than or equal to 40 sccm and less than or equal to 100 sccm; and the second etching gas may include Ar and SF₆.

In an embodiment of the present application, the structure to be etched may be subjected to plasma etching and ion beam etching multiple times to obtain second trenches with different depths and curved bottom shapes and to improve the roughness of the second trenches, enhancing the appearance quality of the second trenches.

The operation of carrying out plasma etching on the structure to be etched with a first etching gas while taking a mask layer as a shield to form a first trench, and the operation of carrying out ion beam etching on the first trench with a second etching gas while taking a mask layer as a shield to modify the bottom surface of the first trench and obtain a second trench, may be repeated until the depth of the second trench reaches the preset depth.

In the embodiment of the present application, the structure to be etched is subjected to plasma etching by using the first etching gas to form the first trench. Subsequently, while taking the mask layer as a shield, the first trench is subjected to ion beam etching by using the second etching gas to modify the bottom surface of the first trench and obtain the second trench. In this way, by performing ion beam etching with the second etching gas after plasma etching, the first trench can be modified to form a smooth curved trench bottom, thereby avoiding the formation of micro-trenches and addressing structural defects arising from the processing and manufacturing of grooved devices. As a result, the device performance is improved.

In S1022, while taking the mask layer as a shield, ion beam etching is performed on the structure to be etched with a second etching gas to form a first trench.

In an embodiment of the present application, the ion beam etching (IBE) may be carried out on the structure to be etched with the second etching gas while taking the mask layer as a shield, thereby forming a first trench in the structure to be etched. The second etching gas exists in the form of a plasma, which may also be referred to as the second etching gas plasma. The first trench may be in a V-shaped structure or an inverted trapezoidal structure. The inverted trapezoidal structure may have both inclined sidewalls, or one inclined sidewall and the other vertical sidewall. In this way, the part of the bottom of the first trench near the sidewalls is higher than the other parts, which can prevent the formation of micro-trenches. As shown in FIG. 8, it shows a schematic structural view of a structure to be etched according to another embodiment of the present application, which has a first trench. By being obliquely incident the second etching gas onto the structure 101 to be etched for etching, a V-shaped first trench 103 can be obtained.

The second etching gas may include an inert gas, which may include at least one of Ar, He, Kr, and Xe, so that the inert gas is ionized into an ion beam for etching the structure to be etched.

The second etching gas may further include a reactive gas that may chemically react with the structure to be etched to increase the etching rate. The reactive gas may include at least one of SF₆, CHF₃, CF₄, and NF₃.

The apparatus used for ion beam etching may be at least one of an ion beam etching apparatus, a reaction ion beam etching (RIBE) apparatus, and a chemical ion beam etching (CIBE) apparatus. Ion beam etching refers to the process of filling an ion source discharge chamber with an inert gas, ionizing the inert gas to form ions, and enabling the ions to be in a beam shape by a grid and accelerated, so that the ion beam with certain energy enters the working chamber, moves towards the solid surface and bombards the solid surface atoms, causing the material atoms to sputter and achieving the etching purpose. Reaction ion beam etching involves filling the ion source with a reactive gas and ionizing the reactive gas as well, which not only achieves physical etching by the ion beam but also enables the reactive gas to undergo chemical reactions with the structure to be etched, accelerating the etching rate. Chemical ion beam etching involves generating a high-energy ion beam through an ion source and filling the vacuum chamber with a reactive gas to etch the structure to be etched. In this way, the ions bombarding the structure to be etched and the gas reacting with the structure to be etched can be controlled separately, meaning that the anisotropic and isotropic etching of the structure to be etched can be independently controlled.

In an embodiment of the present application, the angle and depth of the first trench may be altered by changing parameters such as the incidence angle of the ion beam, the energy of the ion beam, and the beam current density of the ion beam, thereby obtaining U-shaped trenches with different depths and curved bottom shape.

The step of carrying out ion beam etching on the structure to be etched with a second etching gas while taking the mask layer as a shield to form the first trench may include: determining the incidence angle of the ion beam relative to the structure to be etched, the energy of the ion beam, and the beam current density of the ion beam based on the preset depth and width of the second trench, the ion beam being formed by ionizing the second etching gas; while taking the mask layer as a shield, performing ion beam etching on the structure to be etched by using the ion beam based on the incidence angle of the ion beam relative to the structure to be etched, the energy of the ion beam, and beam current density of the ion beam, so as to form the first trench, which has a target depth and a target width.

In an embodiment of the present application, when the first etching is ion beam etching, the incidence angle of the ion beam relative to the structure to be etched may be less than or equal to 50 degrees during ion beam etching, which allows for the formation of the first trench while avoiding excessive etching of the sidewalls and bottom surface of the first trench. The rotation speed of the ion beam emitting device may be less than or equal to 20 rpm. The energy of the ion beam may be greater than or equal to 400 V and less than or equal to 1000 V. The accelerating voltage of the ion beam may be 20% of the energy of the ion beam. The beam current density of the ion beam may be greater than or equal to 100 mA and less than or equal to 1000 mA.

If the structure to be etched includes silicon carbide material and the first etching is ion beam etching, the incidence angle of the ion beam relative to the structure to be etched may be 50 degrees; the energy of the ion beam may be 400 V; the accelerating voltage of the ion beam may be 80 V; the beam current density of the ion beam may be 510 mA; the chamber pressure required during ion beam etching may be 1 mT; the gas flow rate of the second etching gas may be 30 sccm; and the second etching gas may include Ar and SF₆.

In S1032, while taking mask layer as a shield, plasma etching is carried out on the first trench with a first etching gas to form a second trench.

In the embodiment of the present application, the plasma etching may be carried out on the first trench with the first etching gas by taking the mask layer as a shield to form the second trench. The first etching gas exists in the form of a plasma and may also be referred to as the first etching gas plasma. Since the first trench has a V-shaped structure or an inverted trapezoidal structure, the part of the bottom of the second trench near the sidewalls will not form micro-trenches due to excessive etching. The second trench may have a U-shaped structure, which can avoid the formation of micro-trenches and improve device performance. Referring to FIG. 9, it shows a schematic structural view of a structure to be etched according to another embodiment of the present application, which has a second trench. A U-shaped second trench 104 is formed in the structure 101 to be etched.

In an embodiment of the present application, the second trench may include multiple independent sub-trenches. The multiple independent sub-trenches may have the same depth but not necessarily the same width, thereby forming trenches with different widths based on actual needs. For example, some of the sub-trenches may have a width of 2.5 µm, whereas others may have a width of 4 µm. In FIG. 9, two second trenches 104 of different widths are formed on the structure to be etched.

The first etching gas may include SF₆ and O₂. When the structure to be etched includes silicon carbide material, SF₆ not only serves the purpose of ion bombardment but also ionizes to produce fluorine ions. These fluorine ions react with silicon carbide to generate volatile substances, thereby accelerating the etching rate. O₂ may be mixed into SF₆ to control the etching rate and trench shape.

The first etching gas may further include HBr, which may not only perform ion bombardment etching but also react with silicon carbide to produce polymers. These polymers adhere to the sidewalls of the second trench, protecting them from being etched.

The first etching gas may further include an inert gas. The inert gas may include at least one of Ar, He, Kr, and N₂, which can achieve physical etching and protect the structure to be etched from over-etching.

In a possible implementation, before using the second etching gas to perform ion beam etching on the structure to be etched while taking the mask layer as a shield to form the first trench, the structure to be etched may be placed into an ion beam etching chamber. The structure to be etched may be placed into an ion beam etching chamber by using a robotic arm.

Before using the first etching gas to perform plasma etching on the first trench while taking the mask layer as a shield to form the second trench, the structure to be etched with the first trench may be transferred to a plasma etching chamber. The structure to be etched may be taken out of the ion beam etching chamber and placed into the plasma etching chamber by using a robotic arm.

The structure to be etched may be placed into the ion beam etching chamber, and the second etching gas is introduced into the ion beam etching chamber, so that a first trench can be obtained through ion beam etching. The first trench has a bottom of an inverted triangular structure with different slopes, that is, a V-shaped structure. Subsequently, the structure to be etched with the first trench may be transferred to the plasma etching chamber, and the first etching gas is introduced into the plasma etching chamber. The first etching gas is ionized to etch the surface of the structure to be etched, resulting in a U-shaped trench with a curved bottom.

In another possible implementation, the process of using the second etching gas to perform ion beam etching on the structure to be etched and the process of using the first etching gas to perform plasma etching on the first trench may be carried out in the same chamber, e.g., an ion beam etching chamber, a plasma etching chamber, or any other reaction chamber. In this case, the structure to be etched may be placed into the reaction chamber before performing ion beam etching with the second etching gas on the structure to be etched, and remain there until both the ion beam etching and plasma etching are completed.

In an embodiment of the present application, the plasma etching may include inductively coupled plasma (ICP) etching or capacitively coupled plasma (CCP) etching. The first trench may be subjected to ICP etching by using an ICP processing apparatus or subjected to CCP etching by using a CCP processing apparatus. The ICP processing apparatus introduces the energy of a radio frequency (RF) power source into the reaction chamber in the form of magnetic field coupling through an inductive coil, thereby generating plasma for etching. The CCP processing apparatus forms plasma in the reaction chamber through capacitive coupling of an RF or direct current (DC) power source applied to electrodes, achieving etching.

In a possible implementation, the step of using a first etching gas to perform plasma etching on the first trench while taking the mask layer as a shield to form a second trench may include: determining the chamber pressure, RF power of a first RF source, RF power of a second RF source, and the temperature of a lower electrode required during plasma etching based on the preset depth and width or the target depth and width of the second trench. The first RF source is used to ionize the first etching gas to form plasma, so as to perform plasma etching on the structure to be etched through the plasma. The second RF source is used to control a downward movement of the plasma to contact the structure to be etched, thereby achieving anisotropic etching. The lower electrode is used to place the structure to be etched, and the second RF source is connected to the lower electrode. Subsequently, while taking the mask layer as a shield, the first trench is subjected to plasma etching with the first etching gas based on the chamber pressure, RF power of the first RF source, RF power of the second RF source, and the temperature of the lower electrode required during plasma etching, so as to form the second trench. This allows for the fabrication of a second trench with the preset width and preset depth, improving the accuracy of etching. It is also possible to adjust relevant parameters to regulate the vertical profile of the trench sidewall and the etching rate, obtaining a trench of a specified depth.

In an embodiment of the present application, the chamber pressure required during plasma etching may be larger than or equal to 5 mT and less than or equal to 80 mT. The RF power of the first RF source may be larger than or equal to 50 W and less than or equal to 1200 W. The RF power of the second RF source may be less than or equal to 500 W. The temperature of the lower electrode may be less than or equal to 60 degrees Celsius.

When the second etching is plasma etching, the chamber pressure required during plasma etching may be 8 mT; the RF power of the first RF source may be 400 W; the RF power of the second RF source may be 100 W; and the first etching gas may include SF₆ and O₂. The gas flow rate of the first etching gas may be greater than or equal to 40 sccm and less than or equal to 80 sccm.

In an embodiment of the present application, the structure to be etched may be repeatedly subjected to ion beam etching and plasma etching multiple times to obtain second trenches with different depths and different curved bottom profiles. This may also improve the roughness of the second trenches and enhance their profile quality.

The operation of performing ion beam etching on the structure to be etched with a second etching gas while taking the mask layer as a shield so as to form a first trench, and the operation of performing plasma etching on the first trench with a first etching gas while taking the mask layer as a shield so as to form a second trench may be repeated until the second trench has the preset width, the preset depth, and the preset angle between the sidewall and the bottom surface of the second trench, thereby meeting the preset requirements.

In an embodiment of the present application, the ion beam etching is performed on the structure to be etched by using the second etching gas to form a first trench. The first trench has a V-shaped structure or an inverted trapezoidal structure, and there are no micro-trenches at the part of the bottom of the first trench near the sidewalls. Subsequently, while taking the mask layer as a shield, the plasma etching is performed on the first trench with the first etching gas to form a second trench, and the second trench has a U-shaped structure. In this way, since the part of the bottom of the first trench near the sidewalls is thicker than the other parts, when further etching the first trench to form the second trench, the part of the bottom of the second trench near the sidewalls will not form micro-trenches due to over-etching. The second trench has a U-shaped structure, which can avoid the formation of micro-trenches and improve device performance.

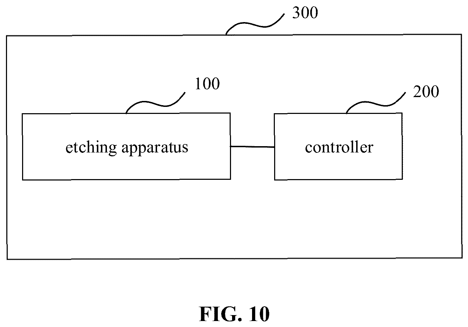

Based on the above etching method, an etching system is further provided according to the embodiments of the present application. Referring to FIG. 10, it is a schematic structural view of an etching system provided by the embodiments of the present application. The etching system 300 may include an etching apparatus 100 and a controller 200. The etching apparatus 100 may include a first etching apparatus for performing plasma etching and a second etching apparatus for performing ion beam etching. The first etching apparatus and the second etching apparatus may be the same etching apparatus or different etching apparatuses. The controller 200 is used to execute the etching method.

An etching system is provided according to the embodiments of the present application, including an etching apparatus and a controller. The etching apparatus includes a first etching apparatus for performing plasma etching on the structure to be etched with a first etching gas and a second etching apparatus for performing ion beam etching on the first trench with a second etching gas. The controller is used to execute the etching method. In this way, after performing plasma etching, performing ion beam etching with the second etching gas can modify the first trench to form a smooth curved trench bottom, thereby avoiding the formation of micro-trenches, solving structural defects in the manufacturing of grooved devices, and improving device performance.

Alternatively, an etching system is provided according to the embodiments of the present application, including an etching apparatus and a controller. The etching apparatus includes a second etching apparatus for performing ion beam etching on the structure to be etched with a second etching gas and a first etching apparatus for performing plasma etching on the structure to be etched with a first etching gas. The controller is used to execute the etching method. Since the part of the bottom of the first trench near the sidewalls is higher than the other parts, when further etching the first trench to form the second trench, the part of the bottom of the second trench near the sidewalls will not form micro-trenches due to excessive etching. The second trench has a U-shaped structure, which can avoid the formation of micro-trenches and improve device performance.

The above embodiments in this specification are described in a progressive manner. References may be made among these embodiments with respect to the same or similar portions among these embodiments, and each of the embodiments is mainly focused on describing its differences from other embodiments. Especially, for the apparatus embodiments, since they are similar with the method embodiments, the description of the apparatuses is simple, and reference may be made to the relevant part of the method embodiments.

The preferred embodiments according to the present application are disclosed above, and are not intended to limit the present application. With the method and technical content disclosed above, those skilled in the art can make some variations and improvements to the technical solutions of the present application, or make some equivalent variations on the embodiments without departing from the scope of technical solutions of the present application. All simple modifications, equivalent variations and improvements made based on the technical essence of the present application without departing the content of the technical solutions of the present application fall within the protection scope of the technical solutions of the present application.

## Claims

1. An etching method, comprising:
providing a structure to be etched, which is covered with a patterned mask layer;
performing a first etching on the structure to be etched while taking the mask layer as a shield, so as to form a first trench; and
performing a second etching on the first trench while taking the mask layer as the shield, so as to form a second trench;
wherein one of the first etching and the second etching is plasma etching, and the other is ion beam etching.

2. The method according to claim 1, wherein the step of performing the first etching on the structure to be etched while taking the mask layer as the shield so as to form a first trench comprises:
performing plasma etching on the structure to be etched by using a first etching gas while taking the mask layer as the shield so as to form the first trench; and
the step of performing the second etching on the first trench while taking the mask layer as the shield so as to form the second trench comprises:
performing ion beam etching on the first trench by using a second etching gas while taking the mask layer as the shield so as to modify a bottom surface of the first trench to form the second trench.

3. The etching method according to claim 1, wherein the step of performing the first etching on the structure to be etched while taking the mask layer as the shield so as to form the first trench comprises:
performing ion beam etching on the structure to be etched by using a second etching gas plasma while taking the mask layer as the shield so as to form the first trench, wherein the first trench is of a V-shaped structure or an inverted trapezoidal structure; and
the step of performing the second etching on the first trench while taking the mask layer as the shield so as to form a second trench comprises:
performing plasma etching on the first trench by using a first etching gas plasma while taking the mask layer as the shield so as to form the second trench, wherein the second trench is of a U-shaped structure.

4. The etching method according to claim 2 or 3, wherein the first etching gas comprises SF₆ and O₂.

5. The etching method according to claim 4, wherein the structure to be etched comprises silicon carbide material, a flow ratio of SF₆ to O₂ is 1:2, and a sum of flow of SF₆ and O₂ accounts for at least 5% of flow of the first etching gas.

6. The etching method according to claim 4, wherein the first etching gas further comprises HBr.

7. The etching method according to claim 4, wherein the first etching gas further comprises an inert gas, the inert gas comprises at least one of Ar, He, Kr, and N₂, and when the first etching gas is used to form the first trench, flow of the inert gas accounts for more than 30% of flow of the first etching gas.

8. The etching method according to claim 2 or 3, wherein the structure to be etched comprises silicon carbide material, the second etching gas comprises an inert gas, and the inert gas comprises at least one of Ar, He, Kr, and Xe.

9. The etching method according to claim 8, wherein the second etching gas further comprises a reactive gas, and the reactive gas comprises at least one of SF₆, CHF₃, CF₄, and NF₃.

10. The etching method according to any one of claims 1 to 9, wherein, before the step of performing the first etching on the structure to be etched while taking the mask layer as the shield, the etching method further comprises:
placing the structure to be etched into a first etching chamber; the first etching chamber is a plasma etching chamber when the first etching is plasma etching, or is an ion beam etching chamber when the first etching is ion beam etching; and
before the step of performing the second etching on the first trench while taking the mask layer as the shield, the etching method further comprises:
transferring the structure to be etched, which has formed with the first trench, into a second etching chamber, wherein the second etching chamber is a plasma etching chamber when the second etching is plasma etching, or is an ion beam etching chamber when the second etching is ion beam etching.

11. The etching method according to claim 2, further comprising:
repeating the step of performing plasma etching on the structure to be etched by using the first etching gas while taking the mask layer as the shield so as to form a first trench, and the step of performing ion beam etching on the first trench by using the second etching gas while taking the mask layer as the shield so as to modify the bottom surface of the first trench to obtain a second trench, until a depth of the second trench reaches a preset depth.

12. The etching method according to claim 3, further comprising:
repeating the step of performing ion beam etching on the structure to be etched by using the second etching gas plasma while taking the mask layer as the shield to form a first trench, and the step of performing plasma etching on the first trench by using the first etching gas plasma while taking the mask layer as the shield to form a second trench, until the second trench has a preset width, a preset depth, and a preset angle between a sidewall of the second trench and a bottom surface of the second trench.

13. The etching method according to claim 2, wherein the step of performing plasma etching on the structure to be etched by using the first etching gas while taking the mask layer as the shield so as to form the first trench comprises:
determining a chamber pressure, a radio frequency power of a first radio frequency source, a radio frequency power of a second radio frequency source, and a temperature of a lower electrode required during plasma etching based on a preset depth and a preset width of the second trench, wherein the first radio frequency source is configured to ionize the first etching gas to form plasma, the second radio frequency source is configured to control the plasma to move downwards to contact the structure to be etched, and the lower electrode is configured to place the structure to be etched and is connected to the second radio frequency source; and
performing plasma etching on the structure to be etched by using the first etching gas while taking the mask layer as a shield based on the chamber pressure, the radio frequency power of the first radio frequency source, the radio frequency power of the second radio frequency source, and the temperature of the lower electrode required during plasma etching, so as to form the first trench with a target depth and a target width.

14. The etching method according to claim 3, wherein the step of performing ion beam etching on the structure to be etched by using the second etching gas plasma while taking the mask layer as the shield so as to form the first trench comprises:
determining an incident angle of the ion beam relative to the structure to be etched, energy of the ion beam, and beam current density of the ion beam based on a preset depth and a preset width of the second trench, wherein the ion beam is formed by ionizing the second etching gas; and
performing ion beam etching on the structure to be etched by using an ion beam while taking the mask layer as the shield based on the incident angle of the ion beam relative to the structure to be etched, the energy of the ion beam, and the beam current density of the ion beam, so as to form the first trench with a target depth and a target width.

15. The etching method according to claim 14, wherein the step of performing plasma etching on the first trench by using the first etching gas plasma while taking the mask layer as the shield so as to form the second trench comprises:
determining a chamber pressure, a radio frequency power of a first radio frequency source, a radio frequency power of a second radio frequency source, and a temperature of a lower electrode required during plasma etching based on a preset depth and a preset width or a target depth and a target width of the second trench, wherein the first radio frequency source is configured to ionize the first etching gas to form plasma, the second radio frequency source is configured to control the plasma to move downwards to contact the structure to be etched, and the lower electrode is configured to place the structure to be etched and is connected to the second radio frequency source; and
performing plasma etching on the first trench by using a second etching gas plasma while taking the mask layer as the shield based on the chamber pressure, the radio frequency power of the first radio frequency source, the radio frequency power of the second radio frequency source, and the temperature of the lower electrode required during plasma etching, so as to form the second trench.

16. The etching method according to claim 13 or 15, wherein the chamber pressure required during plasma etching is greater than or equal to 5 mT and less than or equal to 80 mT, the radio frequency power of the first radio frequency source is greater than or equal to 50 W and less than or equal to 1200 W, the radio frequency power of the second radio frequency source is less than or equal to 500 W, and the temperature of the lower electrode is less than or equal to 60 degrees Celsius.

17. The etching method according to claim 16, wherein the structure to be etched comprises silicon carbide material and the first etching is plasma etching, the chamber pressure required during plasma etching is 10 mT, the radio frequency power of the first radio frequency source is 400 W, the radio frequency power of the second radio frequency source is 80 W, and the first etching gas comprises SF₆, O₂, and Ar, with a gas flow rate of the first etching gas greater than or equal to 40 sccm and less than or equal to 120 sccm.

18. The etching method according to claim 16, wherein the second etching is plasma etching, the chamber pressure required during plasma etching is 8 mT, the radio frequency power of the first radio frequency source is 400 W, the radio frequency power of the second radio frequency source is 100 W, and the second etching gas comprises SF₆ and O₂, with a gas flow rate of the second etching gas greater than or equal to 40 sccm and less than or equal to 80 sccm.

19. The etching method according to claim 13, wherein the step of performing ion beam etching on the first trench by using the second etching gas while taking the mask layer as the shield so as to modify the bottom surface of the first trench to form the second trench comprises:
determining energy and beam current density of an ion beam based on a preset depth and a preset width or a target depth and a target width of the second trench, wherein the ion beam is formed by ionizing the second etching gas; and
performing ion beam etching on the first trench by using the second etching gas while taking the mask layer as the shield based on the energy and the beam current density of the ion beam, so as to modify the bottom surface of the first trench to form the second trench.

20. The etching method according to claim 14 or 19, wherein when the second etching is ion beam etching, the ion beam is incident perpendicularly to the structure to be etched; or when the first etching is ion beam etching, an incident angle of the ion beam relative to the structure to be etched is less than or equal to 50 degrees; and
a rotational speed of an ion beam emitter is less than or equal to 20 rpm, the energy of the ion beam is greater than or equal to 400 V and less than or equal to 1000 V, the acceleration voltage of the ion beam is 20% of the energy of the ion beam, and the beam current density of the ion beam is greater than or equal to 100 mA and less than or equal to 1000 mA.

21. The etching method according to claim 20, wherein the structure to be etched comprises silicon carbide material and the second etching is ion beam etching, the energy of the ion beam is 500 V, the acceleration voltage of the ion beam is 100 V, the beam current density of the ion beam is 400 mA, the chamber pressure required during ion beam etching is 3 mT, and the gas flow rate of the second etching gas is greater than or equal to 40 sccm and less than or equal to 100 sccm, and the second etching gas comprises Ar and SF₆.

22. The etching method according to claim 20, wherein when the first etching is ion beam etching, an incident angle of the ion beam relative to the structure to be etched is 50 degrees, the energy of the ion beam is 400 V, the acceleration voltage of the ion beam is 80 V, the beam current density of the ion beam is 510 mA, the chamber pressure required during ion beam etching is 1 mT, and the gas flow rate of the second etching gas is 30 sccm, and the second etching gas comprises Ar and SF₆.

23. The etching method according to any one of claims 1 to 22, wherein the second trench comprises a plurality of mutually independent sub-trenches, the depths of the plurality of mutually independent sub-trenches are the same, and the widths of the plurality of mutually independent sub-trenches are not all the same.

24. The etching method according to any one of claims 1 to 23, further comprising:
forming the patterned mask layer on the structure to be etched by nanoimprinting, photolithography, or etching process.

25. The etching method according to any one of claims 1 to 24, wherein material of the mask layer is at least one of photoresist, silicon oxide, silicon nitride, and metal.

26. The etching method according to any one of claims 1 to 25, wherein the apparatus for performing ion beam etching is at least one of an ion beam etching apparatus, a reactive ion beam etching apparatus, and a chemically assisted ion beam etching apparatus.

27. The etching method according to any one of claims 1 to 26, wherein the structure to be etched comprises a silicon carbide substrate, or the structure to be etched comprises a substrate and a silicon carbide layer located on a side of the substrate.

28. An etching system, comprising an etching apparatus and a controller, wherein
the etching apparatus comprises a first etching apparatus for performing plasma etching and a second etching apparatus for performing ion beam etching, and the controller is configured to execute the etching method according to any one of claims 1 to 27.
